# EUROPEAN PATENT APPLICATION

(11) **EP 4 498 371 A1**
(43) Date of publication of application: **29.01.2025**
(21) Application number: 23914182.3
(22) Date of filing: 23.04.2023
(51) Int. Cl.: G11C 11/4063

(54) **CONTROL CIRCUIT, CONTROL METHOD AND MEMORY**

(30) Priority: 05.01.2023 CN 202310013979
(71) Applicant: CXMT Corporation, Hefei, Anhui 230601 (CN)
(72) Inventor: ZHANG, Zhiqiang, Hefei, Anhui 230601 (CN)
(74) Representative: Gulde & Partner
(86) International application number: PCT/CN2023/090039
(87) International publication number: WO 2024/146031

(57) **Abstract**

Embodiments of the present disclosure provide a control circuit, a control method, and a memory. The control circuit includes: an input control module, configured to generate a first drive control signal and a second drive control signal based on a command/address control signal and a command/address inversion signal; an input processing module, configured to generate a first intermediate command/address signal based on the first drive control signal and the second drive control signal when the command/address control signal is in an enabled state, that the circuit is in a power down mode being indicated when the command/address control signal is in the enabled state; and a logic decoding module, configured to generate a power down mode exit signal in the power down mode based on the command/address inversion signal and the first intermediate command/address signal.

## Description

### CROSS-REFERENCE TO RELATED APPLICATIONS

The present disclosure claims priority to Chinese Patent Application No. 202310013979.5, filed with the China National Intellectual Property Administration on January 5, 2023 and entitled "CONTROL CIRCUIT, CONTROL METHOD, AND MEMORY", which is incorporated herein by reference in its entirety.

### TECHNICAL FIELD

The present disclosure relates to but is not limited to a control circuit, a control method, and a memory.

### BACKGROUND

A dynamic random access memory (DRAM) has a power down mode. The memory enters the power down mode after a power down mode entry signal is received. In the power down mode, many circuits in the memory stop working, and the memory is in a low power state as a whole. After a power down mode exit signal is received, the memory exits the power down mode, and returns to a normal working state. However, when command/address inversion exists, the circuit may have the problem that decoding cannot be normally performed to obtain the power down mode exit signal.

### SUMMARY

Embodiments of the present disclosure provide a control circuit, a control method, and a memory.

According to a first aspect, an embodiment of the present disclosure provides a control circuit, including:
an input control module, configured to: receive a command/address control signal and a command/address inversion signal, and generate a first drive control signal and a second drive control signal based on the command/address control signal and the command/address inversion signal;
an input processing module, configured to: receive the command/address control signal, the first drive control signal, and the second drive control signal, and generate a first intermediate command/address signal based on the first drive control signal and the second drive control signal when the command/address control signal is in an enabled state, that the circuit is in a power down mode being indicated when the command/address control signal is in the enabled state; and
a logic decoding module, configured to: receive the first intermediate command/address signal and the command/address inversion signal, and generate a power down mode exit signal in the power down mode based on the command/address inversion signal and the first intermediate command/address signal.

In some embodiments, the input processing module is further configured to: receive an external command/address signal, and generate the first intermediate command/address signal based on the external command/address signal when the command/address control signal is in a disabled state, that the circuit is in a normal mode being indicated when the command/address control signal is in the disabled state; and
the logic decoding module is further configured to generate a power down mode entry signal in the normal mode based on the command/address inversion signal and the first intermediate command/address signal.

In some embodiments, the input processing module includes an input buffer module and a drive module. An output terminal of the input buffer module and an output terminal of the drive module are connected as an output terminal of the input processing module, and are connected to the logic decoding module.

The input buffer module is configured to: receive the command/address control signal and the external command/address signal, and perform drive enhancement processing on the external command/address signal to obtain the first intermediate command/address signal and output the first intermediate command/address signal from the output terminal of the input buffer module when the command/address control signal is in the disabled state.

The drive module is configured to: receive the first drive control signal and the second drive control signal, and generate the first intermediate command/address signal based on the first drive control signal and the second drive control signal and output the first intermediate command/address signal from the output terminal of the drive module when the command/address control signal is in the enabled state.

In some embodiments, the drive module includes a pull-up module and a pull-down module.

The pull-up module is configured to: receive the first drive control signal, and pull up the output terminal of the drive module to a second level state when the first drive control signal is in a first level state, so that the first intermediate command/address signal is in the second level state.

The pull-down module is configured to: receive the second drive control signal, and pull down the output terminal of the drive module to the first level state when the second drive control signal is in the second level state, so that the first intermediate command/address signal is in the first level state.

In some embodiments, the external command/address signal includes N bits of external command/address sub-signals, the first intermediate command/address signal includes N bits of first intermediate command/address sub-signals, and N is a positive integer.

The input buffer module includes N input buffer sub-modules, and each input buffer sub-module correspondingly receives 1 bit of external command/address sub-signal and the command/address control signal, and generates 1 bit of first intermediate command/address sub-signal based on the 1 bit of external command/address sub-signal when the command/address control signal is in the disabled state.

In some embodiments, the pull-up module includes a first P-type transistor, and the pull-down module includes a first N-type transistor.

A gate terminal of the first P-type transistor is configured to receive the first drive control signal, a first terminal of the first P-type transistor is connected to a power supply terminal, a gate terminal of the first N-type transistor is configured to receive the second drive control signal, a first terminal of the first N-type transistor is connected to a ground terminal, and a second terminal of the first P-type transistor and a second terminal of the first N-type transistor are connected as the output terminal of the drive module, and are configured to output the first intermediate command/address signal.

In some embodiments, the first drive control signal is in the second level state and the second drive control signal is in the first level state when the command/address control signal is in the disabled state; and
the first drive control signal and the second drive control signal are in the same level state when the command/address control signal is in the enabled state.

In some embodiments, the input control module includes a first input control module and a second input control module.

The first input control module is configured to: receive the command/address control signal and the command/address inversion signal, and generate the first drive control signal based on the command/address control signal and the command/address inversion signal.

The second input control module is configured to: receive the command/address control signal and the command/address inversion signal, and generate the second drive control signal based on the command/address control signal and the command/address inversion signal.

In some embodiments, the first input control module includes a first logic module and a first buffer module, and the second input control module includes a second logic module and a second buffer module.

The first logic module is configured to: receive the command/address control signal and the command/address inversion signal, and generate a first intermediate drive control signal based on the command/address control signal and the command/address inversion signal.

The first buffer module is configured to perform drive enhancement processing on the first intermediate drive control signal to generate the first drive control signal.

The second logic module is configured to: receive the command/address control signal and the command/address inversion signal, and generate a second intermediate drive control signal based on the command/address control signal and the command/address inversion signal.

The second buffer module is configured to perform drive enhancement processing on the second intermediate drive control signal to generate the second drive control signal.

In some embodiments, the first logic module includes a first tri-state gate and a second P-type transistor, an input terminal of the first tri-state gate is configured to receive the command/address inversion signal, both a control terminal of the first tri-state gate and a gate terminal of the second P-type transistor are configured to receive the command/address control signal, a first terminal of the second P-type transistor is connected to a power supply terminal, and both a second terminal of the second P-type transistor and an output terminal of the first tri-state gate are connected to an input terminal of the first buffer module; and
the second logic module includes a second tri-state gate, a first NOT gate, and a second N-type transistor, an input terminal of the second tri-state gate is configured to receive the command/address inversion signal, both a control terminal of the second tri-state gate and an input terminal of the first NOT gate are configured to receive the command/address control signal, an output terminal of the first NOT gate is connected to a gate terminal of the second N-type transistor, a first terminal of the second N-type transistor is connected to a ground terminal, and both a second terminal of the second N-type transistor and an output terminal of the second tri-state gate are connected to an input terminal of the second buffer module.

In some embodiments, each of the first buffer module and the second buffer module includes an even-numbered quantity of second NOT gates connected in series.

In some embodiments, the logic decoding module includes a logic control module, and an input terminal of the logic control module is connected to the output terminal of the input processing module.

The logic control module is configured to: receive the first intermediate command/address signal and the command/address inversion signal, and perform logical processing based on the command/address inversion signal and the first intermediate command/address signal to generate a second intermediate command/address signal.

In some embodiments, the logic control module is configured to: control the second intermediate command/address signal to be in the same level state as the first intermediate command/address signal when the command/address inversion signal is in the first level state; or control the second intermediate command/address signal to be in an opposite level state to the first intermediate command/address signal when the command/address inversion signal is in the second level state.

In some embodiments, the logic decoding module further includes a first sampling module and a decoding module, an input terminal of the first sampling module is connected to an output terminal of the logic control module, and an input terminal of the decoding module is connected to an output terminal of the first sampling module.

The first sampling module is configured to perform sampling processing on the second intermediate command/address signal to obtain a first sampled signal.

The decoding module is configured to perform decoding processing on the first sampled signal to obtain the power down mode exit signal.

In some embodiments, the second intermediate command/address signal includes N bits of second intermediate command/address sub-signals, the control circuit further includes a control signal generation module, the control signal generation module is connected to the logic control module, and is configured to receive a target command/address signal, the target command/address signal is the nth bit of second intermediate command/address sub-signal in the N bits of second intermediate command/address sub-signals, and n is a positive integer less than or equal to N.

The control signal generation module is further configured to: receive a clock signal, the power down mode entry signal, and the power down mode exit signal; perform sampling processing on the target command/address signal based on the clock signal to generate a second sampled signal; and perform logical processing based on the second sampled signal, the power down mode entry signal, and the power down mode exit signal to generate the command/address control signal.

In some embodiments, the control signal generation module includes a second sampling module and a third logic module.

The second sampling module is configured to: receive the target command/address signal and the clock signal, and perform sampling processing on the target command/address signal based on the clock signal to obtain the second sampled signal.

The third logic module is configured to: receive the power down mode entry signal, the power down mode exit signal, and the second sampled signal, generate a power down mode enable signal based on the power down mode entry signal and the power down mode exit signal, and perform a logical operation based on the second sampled signal and the power down mode enable signal to generate the command/address control signal.

A power down mode enable signal in a valid state is generated when the power down mode entry signal is in the valid state, so that the command/address control signal is in the enabled state; and a power down mode enable signal in an invalid state is generated when the power down mode exit signal is in the valid state, so that the command/address control signal is in the disabled state.

In some embodiments, the second sampling module includes a first D flip-flop, and the third logic module includes a latch module and a first NAND gate.

An input terminal of the first D flip-flop is configured to receive the target command/address signal, a clock terminal of the first D flip-flop is configured to receive the clock signal, an output terminal of the first D flip-flop is connected to a first input terminal of the first NAND gate, and the output terminal of the first D flip-flop is configured to output the second sampled signal.

A first input terminal of the latch module is configured to receive the power down mode entry signal, a second input terminal of the latch module is configured to receive the power down mode exit signal, and an output terminal of the latch module is configured to output the power down mode enable signal.

A second input terminal of the first NAND gate is connected to the output terminal of the latch module, and an output terminal of the first NAND gate is configured to output the command/address control signal.

In some embodiments, the latch module includes a second NAND gate, a third NAND gate, and a third NOT gate.

A first input terminal of the second NAND gate is configured to receive the power down mode entry signal, a second input terminal of the second NAND gate is connected to an output terminal of the third NAND gate, an output terminal of the second NAND gate is separately connected to a first input terminal of the third NAND gate and an input terminal of the third NOT gate, a second input terminal of the third NAND gate is configured to receive the power down mode exit signal, and an output terminal of the third NOT gate is connected to the second input terminal of the first NAND gate.

In some embodiments, the control circuit further includes an input inversion buffer module.

The input inversion buffer module is configured to: receive an input inversion signal, and perform drive enhancement processing on the input inversion signal to obtain the command/address inversion signal.

In some embodiments, the input inversion buffer module includes an even-numbered quantity of fourth NOT gates connected in series.

According to a second aspect, an embodiment of the present disclosure provides a control method, including the steps as follows.

A command/address control signal and a command/address inversion signal are received by an input control module, and a first drive control signal and a second drive control signal are generated based on the command/address control signal and the command/address inversion signal.

The command/address control signal, the first drive control signal, and the second drive control signal are received by an input processing module, and a first intermediate command/address signal is generated based on the first drive control signal and the second drive control signal when the command/address control signal is in an enabled state. That a circuit is in a power down mode is indicated when the command/address control signal is in the enabled state.

The first intermediate command/address signal and the command/address inversion signal are received by a logic decoding module, and a power down mode exit signal is generated in the power down mode based on the command/address inversion signal and the first intermediate command/address signal.

According to a third aspect, an embodiment of the present disclosure provides a memory, including the control circuit according to any implementation of the first aspect.

### BRIEF DESCRIPTION OF DRAWINGS

FIG. 1 is a schematic diagram of structural composition of a control circuit according to an embodiment of the present disclosure;
FIG. 2 is a schematic diagram of structural composition of another control circuit according to an embodiment of the present disclosure;
FIG. 3 is a schematic diagram of structural composition of an input buffer module according to an embodiment of the present disclosure;
FIG. 4 is a schematic diagram of structural composition of an input control module according to an embodiment of the present disclosure;
FIG. 5A is a schematic diagram of structural composition of a logic control module according to an embodiment of the present disclosure;
FIG. 5B is a schematic diagram of structural composition of another logic control module according to an embodiment of the present disclosure;
FIG. 6 is a schematic diagram of structural composition of a control signal generation module according to an embodiment of the present disclosure;
FIG. 7 is a schematic diagram of structural composition of an input inversion buffer module according to an embodiment of the present disclosure;
FIG. 8 is a schematic diagram of signal timing according to an embodiment of the present disclosure;
FIG. 9 is a schematic flowchart of a control method according to an embodiment of the present disclosure; and
FIG. 10 is a schematic diagram of structural composition of a memory according to an embodiment of the present disclosure.

### DESCRIPTION OF EMBODIMENTS

The technical solutions in the embodiments of the present disclosure are clearly and completely described below with reference to the accompanying drawings in the embodiments of the present disclosure. It may be understood that specific embodiments described herein are merely intended to explain related disclosure, but are not intended to limit the present disclosure. In addition, it should be further noted that for ease of description, only a part related to the related disclosure is shown in the accompanying drawings.

Unless otherwise defined, all technical and scientific terms utilized in this specification have meanings the same as those commonly understood by a person skilled in the technical field of the present disclosure. The terms utilized in this specification are merely intended to describe the embodiments of the present disclosure, but are not intended to limit the present disclosure.

The following descriptions relate to "some embodiments" describing a subset of all possible embodiments. However, it may be understood that "some embodiments" may be the same subset or different subsets of all the possible embodiments, and may be combined with each other when there is no conflict.

It should be noted that the term "first/second/third" in the embodiments of the present disclosure is merely intended to distinguish between similar objects, and does not represent specific sorting for the objects. It may be understood that "first/second/third" may be interchanged for a specific sequence or order if allowed, so that the embodiments of the present disclosure described herein can be implemented in a sequence other than those shown or described herein.

Before the embodiments of the present disclosure are further described in detail, nouns and terms in the embodiments of the present disclosure are first described. The nouns and the terms in the embodiments of the present disclosure are applicable to the following explanations:
command/address (CA);
power down mode;
power down mode exit signal (Power Down Exit Command, PDX CMD/PDX);
power down mode entry signal (Power Down Entry Command, PDE CMD/PDE/PDN CMD/PDN);
double data rate (DDR);
command/address inversion (CAI);
dynamic random access memory (DRAM);
clock enable signal (Clock Enable, CKE);
chip select signal (Chip Select, CS/CS_n);
bank;
P-type metal oxide semiconductor field effect transistor (Positive channel Metal Oxide Semiconductor field effect transistor, PMOS transistor/P-type transistor);
N-type metal oxide semiconductor field effect transistor (Negative channel Metal Oxide Semiconductor field effect transistor, NMOS transistor/N-type transistor); and
D flip-flop (DFF).

For command/address inversion, logic levels on all CA signals are inverted within a DRAM when a CAI pin is connected to VDDQ. Generally, the CAl pin needs to be connected to VSSQ if CA inversion is not required. IDD2P refers to a leakage current existing when the DRAM is in an idle state, a CKE signal and a CS signal are at a low level, a data line remains unchanged, and a command/address line signal works normally. IDD3P refers to a leakage current existing when one or more banks in the DRAM are activated, a CKE signal and a CS signal are at a low level, a data line remains unchanged, and a command/address line signal works normally.

To reduce power consumption of IDD2P/IDD3P, all CA buffers need to be controlled to be disabled in a power down mode. To detect PDX CMD, an output of the CA buffer needs to be at a high level when the CA buffer is disabled. In DDR5, there is a CAI function. It is necessary to consider that PDX CMD may be further obtained normally through decoding when CAI is enabled.

Table 1 shows a decoding table between the CA signal and both PDE and PDX.

**Table 1**

| | CS_n | CA0 | CA1 | CA2 | CA3 | CA4 |
|---|---|---|---|---|---|---|
| PDE | L | H | H | H | L | H |
| PDX | L | H | H | H | H | H |

As shown in Table 1, L represents a low level, and H represents a high level. A power down mode exit signal PDX may be obtained through decoding when CS_n is at a low level and CA0 to CA4 are all at a high level. A power down mode entry signal PDE may be obtained through decoding when CS_n is at a low level, CA3 is at a low level, CA0 to CA2 and CA4 are at a high level, and CA10 is also at a high level.

Based on this, an embodiment of the present disclosure provides a control circuit, including: an input control module, configured to: receive a command/address control signal and a command/address inversion signal, and generate a first drive control signal and a second drive control signal based on the command/address control signal and the command/address inversion signal; an input processing module, configured to: receive the command/address control signal, the first drive control signal, and the second drive control signal, and generate a first intermediate command/address signal based on the first drive control signal and the second drive control signal when the command/address control signal is in an enabled state, that the circuit is in a power down mode being indicated when the command/address control signal is in the enabled state; and a logic decoding module, configured to: receive the first intermediate command/address signal and the command/address inversion signal, and generate a power down mode exit signal in the power down mode based on the command/address inversion signal and the first intermediate command/address signal. In this way, the first intermediate command/address signal is generated based on the first drive control signal and the second drive control signal when the command/address control signal is in the enabled state, and then the power down mode exit signal is generated. This ensures that the power down mode exit signal can be successfully obtained through decoding when CAI is enabled, so that the circuit can smoothly exit the power down mode, thereby facilitating normal working of a memory, and improving performance.

The embodiments of the present disclosure are described below in detail with reference to the accompanying drawings.

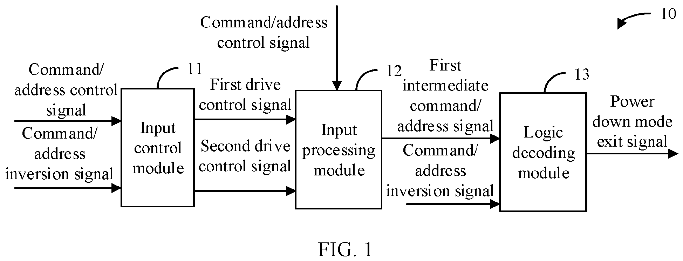

In an embodiment of the present disclosure, refer to FIG. 1, which is a schematic diagram of structural composition of a control circuit according to an embodiment of the present disclosure. As shown in FIG. 1, the control circuit 10 includes:
an input control module 11, configured to: receive a command/address control signal and a command/address inversion signal, and generate a first drive control signal and a second drive control signal based on the command/address control signal and the command/address inversion signal;
an input processing module 12, configured to: receive the command/address control signal, the first drive control signal, and the second drive control signal, and generate a first intermediate command/address signal based on the first drive control signal and the second drive control signal when the command/address control signal is in an enabled state, that the circuit is in a power down mode being indicated when the command/address control signal is in the enabled state; and
a logic decoding module 13, configured to: receive the first intermediate command/address signal and the command/address inversion signal, and generate a power down mode exit signal in the power down mode based on the command/address inversion signal and the first intermediate command/address signal.

It should be noted that the control circuit 10 provided in this embodiment of the present disclosure may be applied to a memory, such as a DRAM or another type of memory, to ensure that the power down mode exit signal (PDX) can be successfully obtained through decoding, especially in the power down mode, ensure that the power down mode exit signal can be successfully obtained through decoding, so that the circuit exits the power down mode.

As shown in FIG. 1, the control circuit 10 may include the input control module 11, the input processing module 12, and the logic decoding module 13. A first input terminal of the input control module 11 receives the command/address control signal, and a second input terminal of the input control module 11 receives the command/address inversion signal. A first output terminal of the input control module 11 is connected to a first drive terminal of the input processing module 12, and is configured to transmit the first drive control signal. A second output terminal of the input control module 11 is connected to a second drive terminal of the input processing module 12, and is configured to transmit the second drive control signal. A control terminal of the input processing module 12 is configured to receive the command/address control signal. An input terminal of the logic decoding module 13 is connected to an output terminal of the input processing module 12, and is configured to receive the first intermediate command/address signal output by the input processing module 12. A control terminal of the logic decoding module 13 is configured to receive the command/address inversion signal, and an output terminal of the logic decoding module 13 is configured to output the power down mode exit signal.

It should be further noted that for the input processing module 12, the command/address control signal is configured to control a working manner of the input processing module 12. It is indicated that the circuit is in the power down mode when the command/address control signal is in the enabled state. In this case, the input processing module 12 generates the first intermediate command/address signal based on the first drive control signal and the second drive control signal, and sends the first intermediate command/address signal to the logic decoding module 13, so that the logic decoding module 13 completes decoding accordingly, to obtain the power down mode exit signal.

It should be further noted that in this embodiment of the present disclosure, for the command/address control signal, that logic 1 indicating a high level represents the enabled state and logic 0 indicating a low level represents a disabled state is taken as an example. However, the logic 0 indicating the low level may represent the enabled state and the logic 1 indicating the high level may represent the disabled state. This is not specifically limited herein.

In this way, the first drive control signal and the second drive control signal are generated by utilizing the command/address control signal and the command/address inversion signal, so that the first intermediate command/address signal is generated based on the two drive control signals when the command/address control signal is in the enabled state, that is, when the circuit is in the power down mode, then the power down mode exit signal is obtained through decoding, to ensure that the power down mode exit signal can be successfully obtained through decoding when command/address inversion is enabled.

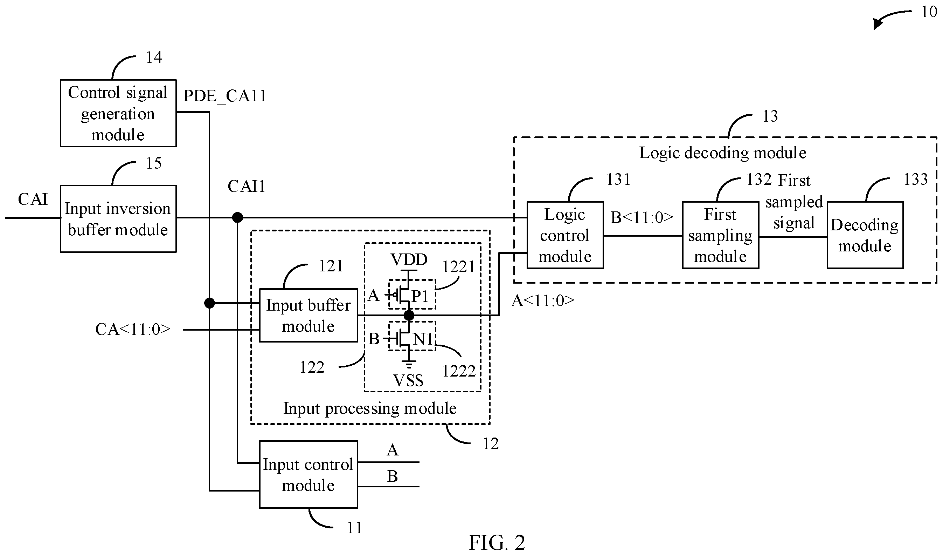

FIG. 2 is a schematic diagram of structural composition of another control circuit according to an embodiment of the present disclosure. In some embodiments, as shown in FIG. 2, the input processing module 12 is further configured to: receive an external command/address signal CA<11:0>, and generate the first intermediate command/address signal A<11:0> based on the external command/address signal CA<11:0> when the command/address control signal PDE_CA11 is in the disabled state, that the circuit is in a normal mode being indicated when the command/address control signal PDE_CA11 is in the disabled state; and
the logic decoding module 13 is further configured to generate a power down mode entry signal in the normal mode based on the command/address inversion signal CAI1 and the first intermediate command/address signal A<11:0>.

It should be noted that as shown in FIG. 2, the input processing module 12 further receives the external command/address signal CA<11:0> through an input terminal of the input processing module 12. The circuit is in the normal mode when the command/address control signal PDE _CA11 is in the disabled state. In this case, the input processing module 12 generates the first intermediate command/address signal A<11:0> based on the external command/address signal CA<11:0>.

That is, in the power down mode, the input processing module 12 generates the first intermediate command/address signal A<11:0> based on the first drive control signal A and the second drive control signal B, and then provides the first intermediate command/address signal A<11:0> to the logic decoding module 13, and the logic decoding module 13 performs processing to generate the power down mode exit signal. In the normal mode, the input processing module 12 generates the first intermediate command/address signal A<11:0> based on the external command/address signal CA<11:0>, and then provides the first intermediate command/address signal A<11:0> to the logic decoding module 13, and the logic decoding module 13 performs processing to generate the power down mode entry signal, and may further generate another command signal required by the circuit.

In this way, in this embodiment of the present disclosure, it can be ensured that in both the normal mode and the power down mode, required command signals are successfully obtained through decoding, to ensure normal functions of the circuit and the memory.

For the input processing module 12, as shown in FIG. 2, in some embodiments, the input processing module 12 includes an input buffer module 121 and a drive module 122. An output terminal of the input buffer module 121 and an output terminal of the drive module 122 are connected as an output terminal of the input processing module 12, and are connected to the logic decoding module 13.

The input buffer module 121 is configured to: receive the command/address control signal PDE_CA11 and the external command/address signal CA<11:0>, and perform drive enhancement processing on the external command/address signal CA<11:0> to obtain the first intermediate command/address signal A<11:0> and output the first intermediate command/address signal A<11:0> from the output terminal of the input buffer module 121 when the command/address control signal PDE_CA11 is in the disabled state.

The drive module 122 is configured to: receive the first drive control signal A and the second drive control signal B, and generate the first intermediate command/address signal A<11:0> based on the first drive control signal A and the second drive control signal B and output the first intermediate command/address signal A<11:0> from the output terminal of the drive module 122 when the command/address control signal PDE_CA11 is in the enabled state.

It should be noted that as shown in FIG. 2, the input processing module 12 includes the input buffer module 121 and the drive module 122. A control terminal of the input buffer module 121 serves as a control terminal of the input processing module 12, and is configured to receive the command/address control signal PDE_CA11. An input terminal of the input buffer module 121 serves as an input terminal of the input processing module 12, and is configured to receive the external command/address signal CA<11:0>. A first drive terminal of the drive module 122 serves as a first drive terminal of the input processing module 12, and is configured to receive the first drive control signal A. A second drive terminal of the drive module 122 serves as a second drive terminal of the input processing module 12, and is configured to receive the second drive control signal B. The output terminal of the input buffer module 121 and the output terminal of the drive module 122 are connected as the output terminal of the input processing module 12, and are configured to output the first intermediate command/address signal A<11:0>.

When the command/address control signal PDE_CA11 is in the disabled state, the circuit is in the normal mode, and the input buffer module 121 is in a working state, and generates the first intermediate command/address signal A<11:0> based on the external command/address signal CA<11:0>. In the power down mode, the drive module 122 is in a working state, and generates the first intermediate command/address signal A<11:0> based on the first drive control signal A and the second drive control signal B.

For the drive module 122, as shown in FIG. 2, in some embodiments, the drive module 122 includes a pull-up module 1221 and a pull-down module 1222.

The pull-up module 1221 is configured to: receive the first drive control signal A, and pull up the output terminal of the drive module 122 to a second level state when the first drive control signal A is in a first level state, so that the first intermediate command/address signal A<11:0> is in the second level state.

The pull-down module 1222 is configured to: receive the second drive control signal B, and pull down the output terminal of the drive module 122 to the first level state when the second drive control signal B is in the second level state, so that the first intermediate command/address signal A<11:0> is in the first level state.

It should be noted that as shown in FIG. 2, the drive module 122 includes the pull-up module 1221 and the pull-down module 1222. The pull-up module 1221 may pull up an output of the drive module 122, and the pull-down module 1222 may pull down the output of the drive module 122.

It should be further noted that an input terminal of the pull-up module 1221 serves as the first drive terminal of the drive module 122, and is configured to receive the first drive control signal A, and an input terminal of the pull-down module 1222 serves as the second drive terminal of the drive module 122, and is configured to receive the second drive control signal B; and an output terminal of the pull-up module 1221 and an output terminal of the pull-down module 1222 are connected as the output terminal of the drive module 122.

The first level state may be the logic 0 indicating the low level, and the second level state may be the logic 1 indicating the high level.

Further, as shown in FIG. 2, the pull-up module 1221 includes a first P-type transistor P1, and the pull-down module 1222 includes a first N-type transistor N1.

A gate terminal of the first P-type transistor P1 is configured to receive the first drive control signal A, a first terminal of the first P-type transistor P1 is connected to a power supply terminal VDD, a gate terminal of the first N-type transistor N1 is configured to receive the second drive control signal B, a first terminal of the first N-type transistor is connected to a ground terminal VSS, and a second terminal of the first P-type transistor P1 and a second terminal of the first N-type transistor N1 are connected as the output terminal of the drive module 122, and are configured to output the first intermediate command/address signal A<11:0>.

It should be noted that as shown in FIG. 2, the gate terminal of the first P-type transistor P1 serves as the input terminal of the pull-up module 1221, the gate terminal of the first N-type transistor N1 serves as the input terminal of 1222, the power supply terminal VDD is configured to provide a high level, and the ground terminal VSS is configured to provide a low level.

When the command/address control signal PDE_CA11 is in the disabled state, in the input processing module 12, the input buffer module 121 works, and the drive module 122 does not work. In this case, the first drive control signal A is in a high-level state (the second level state) and the second drive control signal B is in a low-level state (the first level state), and both the first P-type transistor P1 and the first N-type transistor N1 are turned off, so that neither a level at the output terminal of the drive module 122 is pulled up, nor the level at the output terminal of the drive module 122 is pulled down, but the input buffer module 121 controls a level output by the input processing module 12.

When the command/address control signal PDE_CA11 is in the enabled state, the drive module 122 works. In this case, both the first drive control signal A and the second drive control signal B are in the high-level state (the second level state), or both the first drive control signal A and the second drive control signal B are in the low-level state (the first level state). When both the first drive control signal A and the second drive control signal B are in the high-level state, the first P-type transistor P1 is turned off, and the first N-type transistor N1 is turned on, so that the level at the output terminal of the drive module 122 can be pulled down to the low-level state. When both the first drive control signal A and the second drive control signal B are in the low-level state, the first P-type transistor P1 is turned on, and the first N-type transistor N1 is turned off, so that the level at the output terminal of the drive module 122 can be pulled up to the high-level state.

That is, the first drive control signal A is in the second level state and the second drive control signal B is in the first level state when the command/address control signal PDE _CA11 is in the disabled state; and
the first drive control signal A and the second drive control signal B are in the same level state when the command/address control signal PDE _CA11 is in the enabled state.

In this way, in this embodiment of the present disclosure, the drive module 122 may be formed by utilizing only two transistors. A control manner of the drive module 122 is simple, and a circuit structure is simple and easy to implement.

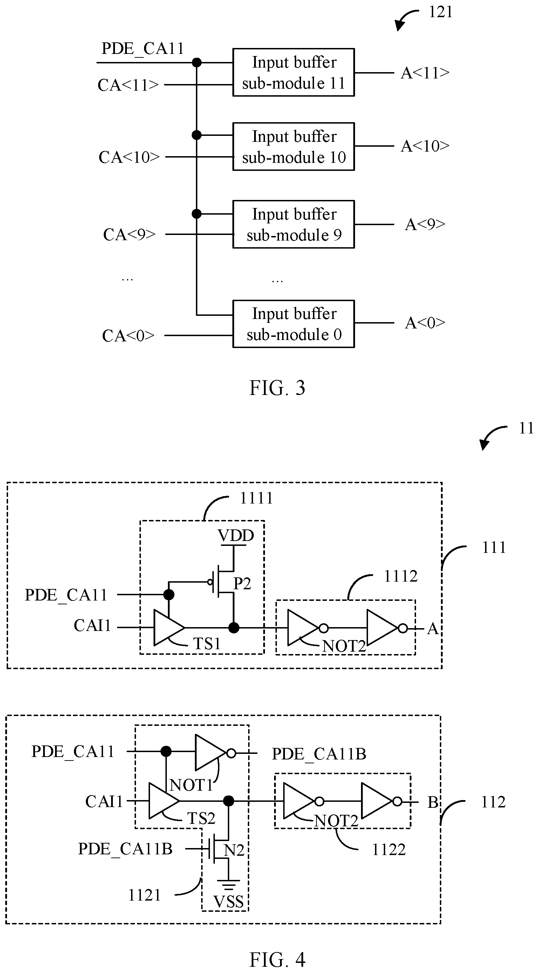

Further, in this embodiment of the present disclosure, the external command/address signal CA<11:0> and the first intermediate command/address signal A<11:0> generally include not only one signal, but include a group of signals. FIG. 3 is a schematic diagram of structural composition of an input buffer module according to an embodiment of the present disclosure. As shown in FIG. 3, in some embodiments, the external command/address signal CA<11:0> includes N bits of external command/address sub-signals, the first intermediate command/address signal A<11:0> includes N bits of first intermediate command/address sub-signals, and N is a positive integer.

The input buffer module 121 includes N input buffer sub-modules, and each input buffer sub-module correspondingly receives 1 bit of external command/address sub-signal and the command/address control signal PDE_CA11, and generates 1 bit of first intermediate command/address sub-signal based on the 1 bit of external command/address sub-signal when the command/address control signal PDE_CA11 is in the disabled state.

It should be noted that N=12 is taken as an example. As shown in FIG. 3, the external command/address signal CA<11:0> includes a total of 12 bits of external command/address sub-signals CA<0>, CA<1>, CA<2>, ..., and CA<11>, and the first intermediate command/address signal A<11:0> includes a total of 12 bits of first intermediate command/address sub-signals A<0>, A<1>, A<2>, ..., and A<11>. Correspondingly, the input buffer module 121 includes 12 buffer sub-modules (or referred to as CA buffers, which may be high-speed buffers), and each buffer sub-module receives the command/address control signal PDE_CA11 and 1 bit of corresponding external command/address sub-signal, and generates 1 bit of corresponding first intermediate command/address sub-signal based on the received 1 bit of corresponding external command/address sub-signal when the command/address control signal PDE_CA11 is in the disabled state.

For example, an input buffer sub-module 11 is taken as an example. As shown in FIG. 3, two input terminals of the input buffer sub-module 11 respectively receive the command/address control signal PDE_CA11 and an external command/address sub-signal CA<11>, and drive enhancement processing is performed on the external command/address sub-signal CA<11> to obtain a first intermediate command/address sub-signal A<11>, and the first intermediate command/address sub-signal A<11> is output from an output terminal of the input buffer sub-module 11 when the command/address control signal PDE_CAT11 is in the enabled state. The first intermediate command/address sub-signal output by the input buffer sub-module may be in the same level state as the received external command/address sub-signal. Working manners of the remaining input buffer sub-modules are the same as this manner. Details are not described herein again.

In addition, a specific structure of each input buffer sub-module may be the same as that of an existing CA buffer. Details are not described herein again, provided that a working state can be entered when the command/address control signal PDE_CA11 is in the enabled state, and a non-working state can be entered when the command/address control signal PDE_CA11 is in the disabled state.

It should be further noted that the input buffer module 121 may alternatively include only one input buffer sub-module. If the external command/address signal includes N bits of external command/address sub-signals, the input buffer module 121 may sequentially perform drive enhancement processing on these external command/address sub-signals, and sequentially output corresponding first intermediate command/address sub-signals.

Further, the drive module 122 is similar to the input buffer module 121, and the drive module 122 may further include N drive sub-modules, which are separately configured to: receive the first drive control signal A and the second drive control signal B, and respectively and correspondingly output all first intermediate command/address sub-signals when the command/address control signal PDE_CA11 is in the enabled state. In this case, the input processing module 12 correspondingly includes N input processing sub-modules, and each input processing sub-module includes one input buffer sub-module and one drive sub-module. When the command/address control signal PDE_CA11 is in the enabled state, the drive sub-module is in a working state, and outputs a corresponding first intermediate command/address sub-signal based on the first drive control signal A and the second drive control signal B. Alternatively, when the command/address control signal PDE_CA11 is in the disabled state, the first drive control signal A is in a high-level state (a second level state) and the second drive control signal B is in a low-level state (a first level state). In this case, the drive sub-module does not work, and the input buffer sub-module is in a working state, performs drive enhancement processing on received 1 bit of external command/address sub-signal, and outputs a corresponding first intermediate command/address sub-signal.

In addition, the drive module 122 may include only one drive sub-module. In this case, an output terminal of the drive sub-module is connected to output terminals of the N input processing sub-modules. When the command/address control signal PDE_CA11 is in the enabled state, the drive sub-module is in a working state, and separately outputs each first intermediate command/address sub-signal based on the first drive control signal A and the second drive control signal B.

That is, in the input processing module 12, there may be N input buffer sub-modules and N drive sub-modules, there may be N input buffer sub-modules and one drive sub-module, or there may even be one input buffer sub-module and N drive sub-modules or one input buffer sub-module and one drive sub-module, or the like. This is not specifically limited herein.

For the input control module 11, refer to FIG. 4, which is a schematic diagram of structural composition of an input control module according to an embodiment of the present disclosure. As shown in FIG. 4, in some embodiments, the input control module 11 includes a first input control module 111 and a second input control module 112.

The first input control module 111 is configured to: receive the command/address control signal PDE_CA11 and the command/address inversion signal CAI1, and generate the first drive control signal A based on the command/address control signal PDE_CA11 and the command/address inversion signal CAI1.

The second input control module 112 is configured to: receive the command/address control signal PDE_CA11 and the command/address inversion signal CAI1, and generate the second drive control signal B based on the command/address control signal PDE_CA11 and the command/address inversion signal CAI1.

It should be noted that as shown in FIG. 4, the input control module 11 includes the first input control module 111 and the second input control module 112, and each of the first input control module 111 and the second input control module 112 includes two input terminals and one output terminal. The two input terminals of each of the first input control module 111 and the second input control module 112 are respectively configured to receive the command/address control signal PDE _CA11 and the command/address inversion signal CAI1. The output terminal of the first input control module 111 is connected to the first drive terminal of the input processing module 12, that is, connected to the gate terminal of the first P-type transistor P1, and the output terminal of the second input control module 112 is connected to the second drive terminal of the input processing module 12, that is, connected to the gate terminal of the first N-type transistor N1.

The first input control module 111 performs processing based on the received signal to obtain the first drive control signal A, and outputs the first drive control signal A from the output terminal of the first input control module 111. The second input control module 112 performs processing based on the received signal to obtain the second drive control signal B, and outputs the second drive control signal B from the output terminal.

Further, as shown in FIG. 4, in some embodiments, the first input control module 111 includes a first logic module 1111 and a first buffer module 1112, and the second input control module 112 includes a second logic module 1121 and a second buffer module 1122.

The first logic module 1111 is configured to: receive the command/address control signal PDE_CA11 and the command/address inversion signal CAI1, and generate a first intermediate drive control signal based on the command/address control signal PDE_CA11 and the command/address inversion signal CAI1.

The first buffer module 1112 is configured to perform drive enhancement processing on the first intermediate drive control signal to generate the first drive control signal A.

The second logic module 1121 is configured to: receive the command/address control signal PDE_CA11 and the command/address inversion signal CAI1, and generate a second intermediate drive control signal based on the command/address control signal PDE_CA11 and the command/address inversion signal CAI1.

The second buffer module 1122 is configured to perform drive enhancement processing on the second intermediate drive control signal to generate the second drive control signal B.

It should be noted that as shown in FIG. 4, in the first input control module 111, two input terminals of the first logic module 1111 serve as the two input terminals of the first input control module 111, and are respectively configured to receive the command/address control signal PDE_CA11 and the command/address inversion signal CAI1; and an output terminal of the first logic module 1111 is connected to an input terminal of the first buffer module 1112, and an output terminal of the first buffer module 1112 serves as the output terminal of the first input control module 111. The first logic module 1111 processes the command/address control signal PDE_CA11 and the command/address inversion signal CAI1 to obtain the first intermediate drive control signal, and then sends the first intermediate drive control signal to the first buffer module 1112. The first buffer module 1112 performs drive enhancement processing on the first intermediate control signal to finally obtain the first drive control signal A.

In the second input control module 112, two input terminals of the second logic module 1121 serve as the two input terminals of the second input control module 112, and are respectively configured to receive the command/address control signal PDE_CA11 and the command/address inversion signal CAI1; and an output terminal of the second logic module 1121 is connected to an input terminal of the second buffer module 1122, and an output terminal of the second buffer module 1122 serves as the output terminal of the second input control module 112. The second logic module 1121 processes the command/address control signal PDE_CA11 and the command/address inversion signal CAI1 to obtain the second intermediate drive control signal, and then sends the second intermediate drive control signal to the second buffer module 1122. The second buffer module 1122 performs drive enhancement processing on the second intermediate control signal to finally obtain the second drive control signal B.

For specific composition of the first input control module 111 and the second input control module 112, as shown in FIG. 4, in some embodiments, the first logic module 1111 includes a first tri-state gate TS1 and a second P-type transistor P2, an input terminal of the first tri-state gate TS1 is configured to receive the command/address inversion signal CAI1, both a control terminal of the first tri-state gate TS1 and a gate terminal of the second P-type transistor P2 are configured to receive the command/address control signal PDE_CA11, a first terminal of the second P-type transistor P2 is connected to a power supply terminal VDD, and both a second terminal of the second P-type transistor P2 and an output terminal of the first tri-state gate TS1 are connected to the input terminal of the first buffer module 1112; and
the second logic module 1121 includes a second tri-state gate TS2, a first NOT gate NOT1, and a second N-type transistor N2, an input terminal of the second tri-state gate TS2 is configured to receive the command/address inversion signal CAI1, both a control terminal of the second tri-state gate TS2 and an input terminal of the first NOT gate NOT1 are configured to receive the command/address control signal PDE_CA11, an output terminal of the first NOT gate NOT1 is connected to a gate terminal of the second N-type transistor N2, a first terminal of the second N-type transistor N2 is connected to a ground terminal VSS, and both a second terminal of the second N-type transistor N2 and an output terminal of the second tri-state gate TS2 are connected to the input terminal of the second buffer module 1122.

In some embodiments, each of the first buffer module 1112 and the second buffer module 1122 includes an even-numbered quantity of second NOT gates NOT2 connected in series.

It should be noted that as shown in FIG. 4, in the first logic module 1111, the input terminal of the first tri-state gate TS1 serves as one input terminal of the first logic module 1111, and is configured to receive the command/address inversion signal CAI1; and the gate terminal of the second P-type transistor P2 serves as the other input terminal of the first logic module 1111, and is configured to receive the command/address control signal PDE_CA11. In addition, the control terminal of the first tri-state gate TS1 also receives the command/address control signal PDE _CA11. When the command/address control signal PDE_CA11 is in the enabled state (the high-level state), the first tri-state gate TS1 is enabled, and the second P-type transistor P2 is turned off, so that the first tri-state gate TS1 can transmit the command/address inversion signal CAI1 received by the input terminal of the first tri-state gate TS1 to the output terminal of the first logic module 1111 as the first intermediate drive control signal. When the command/address control signal PDE_CA11 is in the disabled state (the low-level state), the first tri-state gate TS1 is disabled, and the second P-type transistor P2 is turned on, so that the second P-type transistor P2 can transmit, to the output terminal of the first logic module 1111 as the first intermediate drive control signal, a high level provided by the power supply terminal VDD.

The first buffer module 1112 includes an even-numbered quantity of second NOT gates NOT2 connected in series, an input terminal of the first second NOT gate NOT2 serves as the input terminal of the first buffer module 1112, and an output terminal of the last second NOT gate NOT2 serves as the output terminal of the first buffer module 1112. Two second NOT gates NOT2 are shown in FIG. 4, and there may be four, six, eight, or another quantity of second NOT gates. This is not specifically limited herein. These second NOT gates NOT2 perform drive enhancement processing on the received first intermediate drive control signal to obtain the first drive control signal A. Because there are an even-numbered quantity of second NOT gates NOT2, a level state of a signal is not changed, and only a drive enhancement effect is achieved for the signal, thereby ensuring a drive capability of the signal.

In the second logic module 1121, the input terminal of the second tri-state gate TS2 serves as one input terminal of the second logic module 1121, and is configured to receive the command/address inversion signal CAI1; and the input terminal of the first NOT gate NOT1 serves as the other input terminal of the second logic module 1121, and is configured to receive the command/address control signal PDE _CA11. The first NOT gate NOT1 performs inversion processing on the command/address control signal PDE_CA11 to obtain an inverted signal PDE_CA11B of the command/address control signal as a signal received by the gate terminal of the second N-type transistor N2. In addition, the control terminal of the second tri-state gate TS2 also receives the command/address control signal PDE _CA11. When the command/address control signal PDE CA11 is in the enabled state (the high-level state), the inverted signal PDE _CA11B of the command/address control signal is in the low-level state, the first tri-state gate TS1 is enabled, and the second N-type transistor N2 is turned off, so that the second tri-state gate TS2 can transmit the command/address inversion signal CAI1 received by the input terminal of the second tri-state gate TS2 to the output terminal of the second logic module 1121 as the second intermediate drive control signal. When the command/address control signal PDE _CA11 is in the disabled state (the low-level state), the inverted signal PDE_CA11B of the command/address control signal is in the high-level state, the second tri-state gate TS2 is disabled, and the second N-type transistor N2 is turned on, so that the second N-type transistor N2 can transmit, to the output terminal of the second logic module 1121 as the second intermediate drive control signal, a low level provided by the ground terminal VSS.

The second buffer module 1122 includes an even-numbered quantity of second NOT gates NOT2 connected in series, an input terminal of the first second NOT gate NOT2 serves as the input terminal of the second buffer module 1122, and an output terminal of the last second NOT gate NOT2 serves as the output terminal of the second buffer module 1122. Two second NOT gates NOT2 are shown in FIG. 4, and there may be four, six, eight, or another quantity of second NOT gates. This is not specifically limited herein. These second NOT gates NOT2 perform drive enhancement processing on the received second intermediate drive control signal to obtain the second drive control signal B. Because there are an even-numbered quantity of second NOT gates NOT2, a level state of a signal is not changed, and only a drive enhancement effect is achieved for the signal, thereby ensuring a drive capability of the signal.

That is, for the first input control module 111 and the second input control module 112, when the command/address control signal PDE_CA11 is in the enabled state, both the first drive control signal A and the second drive control signal B are obtained by transmitting the command/address inversion signal CAI1 by the tri-state gate and then performing drive enhancement processing by the even-numbered quantity of second NOT gates NOT2. That is, in this case, both the first drive control signal A and the second drive control signal B are obtained by performing the same processing on the command/address inversion signal CAI1, and the two signals are in the same level state.

When the command/address control signal PDE_CA11 is in the disabled state, the first drive control signal A is obtained by performing drive enhancement processing on a high-level signal provided by the power supply terminal VDD, and a level state of the first drive control signal A is also a high level (the second level state); and the second drive control signal B is obtained by performing drive enhancement processing on a low level signal provided by the ground terminal VSS, and a level state of the second drive control signal B is also a low level (the first level state). In this case, the drive module 122 does not work.

For the logic decoding module 13, as shown in FIG. 2, in some embodiments, the logic decoding module 13 includes a logic control module 131, and an input terminal of the logic control module 131 is connected to the output terminal of the input processing module 12.

The logic control module 131 is configured to: receive the first intermediate command/address signal A<11:0> and the command/address inversion signal CAI1, and perform logical processing based on the command/address inversion signal CAI1 and the first intermediate command/address signal A<11:0> to generate a second intermediate command/address signal B<11:0>.

In some embodiments, the logic decoding module further includes a first sampling module 132 and a decoding module 133, an input terminal of the first sampling module 132 is connected to an output terminal of the logic control module 131, and an input terminal of the decoding module 133 is connected to an output terminal of the first sampling module 132.

The first sampling module 132 is configured to perform sampling processing on the second intermediate command/address signal B<11:0> to obtain a first sampled signal.

The decoding module 133 is configured to perform decoding processing on the first sampled signal to obtain the power down mode exit signal.

It should be noted that as shown in FIG. 2, the logic decoding module 13 includes the logic control module 131, the first sampling module 132, and the decoding module 133. The input terminal of the logic control module 131 serves as the input terminal of the logic decoding module 13, is connected to the output terminal of the input processing module 12, and is configured to receive the first intermediate command/address signal A<11:0>. A control terminal of the logic control module 131 serves as the control terminal of the logic decoding module 13, and is configured to receive the command/address inversion signal CAI1. The command/address inversion signal CAI1 is configured to perform logic control on the logic control module 131, so that the logic control module 131 generates the second intermediate command/address signal B<11:0> based on the first intermediate command/address signal A<11:0>, and then obtains a command signal such as the power down mode exit signal or the power down mode entry signal through decoding based on the second intermediate command/address signal B<11:0>.

Specifically, the logic control module 131 is configured to: control the second intermediate command/address signal B<11:0> to be in the same level state as the first intermediate command/address signal A<11:0> when the command/address inversion signal CAI1 is in the first level state; or control the second intermediate command/address signal B<11:0> to be in an opposite level state to the first intermediate command/address signal A<11:0> when the command/address inversion signal CAI1 is in the second level state.

It should be noted that a function of the logic control module 131 (also referred to as CAI logic) is as follows: B<11:0>=A<11:0> when the command/address inversion signal CAI1 is at a low level; and B<11:0> is equal to an inverted signal of A<11:0> when the command/address inversion signal CAI1 is at a high level.

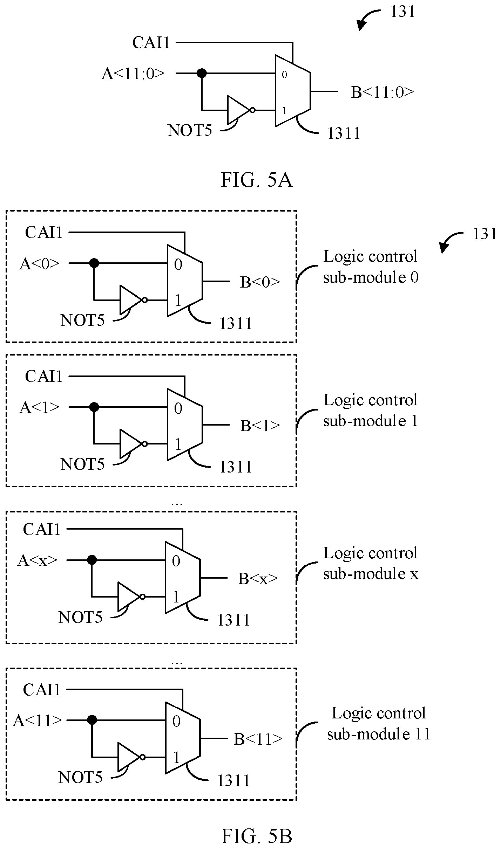

It should be further noted that the logic control module 131 may be implemented by a multiplexer and a NOT gate. FIG. 5A is a schematic diagram of structural composition of a logic control module according to an embodiment of the present disclosure. As shown in FIG. 5A, the logic control module 131 includes a fifth NOT gate NOT5 and a selector 1311.

Both an input terminal of the fifth NOT gate NOT5 and a first input terminal (0) of the selector 1311 are configured to receive the first intermediate command/address signal A<11:0>, and an output terminal of the fifth NOT gate NOT5 is connected to a second input terminal (1) of the selector 1311.

A control terminal of the selector 1311 is configured to receive the command/address inversion signal CAI1. An output terminal of the selector 1311 is configured to output the second intermediate command/address signal B<11:0>.

As shown in FIG. 5A, the input terminal of the fifth NOT gate NOT5 and the second input terminal of the selector 1311 are connected as the input terminal of the logic control module 131, and are configured to receive the first intermediate command/address signal A<11:0>. The control terminal of the selector 1311 serves as the control terminal of the logic control module 131, and is configured to receive the command/address inversion signal CAI1. The fifth NOT gate NOT5 is configured to perform inversion processing on the first intermediate command/address signal A<11:0> to obtain an inverted signal of the first intermediate command/address signal, and provide the inverted signal to the second input terminal of the selector 1311. When the command/address inversion signal CAI1 is in the first level state (the low-level state), the first input terminal of the selector 1311 is enabled, and the second input terminal thereof is disabled, so that the first intermediate command/address signal A<11:0> is selected for transmission to obtain the second intermediate command/address signal B<11:0>. Therefore, the second intermediate command/address signal B<11:0> obtained in this case is in the same level state as the first intermediate command/address signal A<11:0>. When the command/address inversion signal CAI1 is in the second level state (the high-level state), the second input terminal of the selector 1311 is enabled, and the first input terminal thereof is disabled, so that the inverted signal of the first intermediate command/address signal is selected for transmission to obtain the second intermediate command/address signal B<11:0>. Therefore, the second intermediate command/address signal B<11:0> obtained in this case is in the opposite level state to the first intermediate command/address signal A<11:0>.

Further, the second intermediate command/address signal B<11:0> may include N bits of second intermediate command/address sub-signals, and N is a positive integer. Correspondingly, the logic control module 131 includes N logic control sub-modules, and the N logic control sub-modules are respectively in a one-to-one correspondence with both the N bits of first intermediate command/address sub-signals and the N bits of second intermediate command/address sub-signals. FIG. 5B is a schematic diagram of structural composition of another logic control module according to an embodiment of the present disclosure. As shown in FIG. 5B, any logic control sub-module x includes a fifth NOT gate NOT5 and a selector 1311.

Both an input terminal of the fifth NOT gate NOT5 and a first input terminal of the selector 1311 are configured to receive a corresponding first intermediate command/address sub-signal A<x>, an output terminal of the fifth NOT gate NOT5 is connected to a second input terminal of the selector 1311, a control terminal of the selector 1311 is configured to receive the command/address inversion signal CAI1, and an output terminal of the selector 1311 is configured to output a corresponding second intermediate command/address sub-signal B<x>. Herein, x is an integer greater than or equal to 0 and less than N.

As shown in FIG. 5B, N=12 is still taken as an example. The logic control module 131 includes 12 logic control sub-modules: a logic control sub-module 0, a logic control sub-module 1, ..., and a logic control sub-module 11. In the any logic control sub-module x, the input terminal of the fifth NOT gate NOT5 and the first input terminal of the selector 1311 are connected as a first input terminal of the logic control sub-module x, are connected to the output terminal of the input processing module 12, and are configured to receive the first intermediate command/address sub-signal A<x>. The control terminal of the selector 1311 serves as a control terminal of the logic control sub-module, and is configured to receive the command/address inversion signal CAI1. The fifth NOT gate NOT5 is configured to: perform inversion processing on the first intermediate command/address sub-signal A<x> to obtain an inverted signal of the first intermediate command/address sub-signal, and provide the inverted signal to the second input terminal of the selector 1311. When the command/address inversion signal CAI1 is in the first level state (the low-level state), the first input terminal of the selector 1311 is enabled, and the second input terminal thereof is disabled, so that the first intermediate command/address sub-signal A<x> is selected for transmission to obtain the second intermediate command/address sub-signal B<x>. Therefore, the second intermediate command/address sub-signal B<x> obtained in this case is in the same level state as the first intermediate command/address sub-signal A<x>. When the command/address inversion signal CAI1 is in the second level state (the high-level state), the second input terminal of the selector 1311 is enabled, and the first input terminal thereof is disabled, so that the inverted signal of the first intermediate command/address sub-signal is selected for transmission to obtain the second intermediate command/address sub-signal B<x>. Therefore, the second intermediate command/address sub-signal B<x> obtained in this case is in the opposite level state to the first intermediate command/address sub-signal A<x>.

The logic control module 131 sends the obtained second intermediate command/address signal B<11:0> to the first sampling module 132. The first sampling module 132 performs sampling processing to obtain the first sampled signal, and sends the first sampled signal to the decoding module 133. The decoding module 133 performs decoding processing on the first sampled signal to obtain the power down mode exit signal. The first sampling module 132 may be implemented by a D flip-flop, and a working manner of the decoding module 133 is the same as a working manner of an existing decoding circuit. Details are not described herein again.

That is, the logic control module 131 may include one fifth NOT gate NOT5 and one selector 1311 (as shown in FIG. 5A), to sequentially obtain N second intermediate command/address sub-signals after N first intermediate command/address sub-signals are sequentially processed. Alternatively, the logic control module 131 may include N logic control sub-modules, and each logic control sub-module includes one fifth NOT gate NOT5 and one selector 1311 (as shown in FIG. 5B), to obtain N corresponding second intermediate command/address sub-signals after N first intermediate command/address sub-signals are separately processed. Similarly, the first sampled signal may include N first sampled sub-signals. The first sampling module 132 may include one D flip-flop, to sequentially perform sampling processing on the N second intermediate command/address sub-signals to sequentially obtain the N corresponding first sampled sub-signals. Alternatively, the first sampling module 132 may include N D flip-flops, to respectively perform sampling processing on the N second intermediate command/address sub-signals to obtain the N corresponding first sampled sub-signals; and provide the N first sampled sub-signals to the decoding module 133. The decoding module 133 completes decoding based on the N first sampled sub-signals and with reference to a chip select signal, to obtain the command signal.

For example, corresponding to the foregoing Table 1 and related descriptions, when the command/address control signal PDE_CA11 is at a high level, second intermediate command/address sub-signals corresponding to CA<0> to CA<4> are set to a high level, and the logic decoding module 13 performs decoding processing in response to the chip select signal CS based on the command/address signals, to output the power down mode exit signal PDX. When the command/address control signal PDE_CA11 is at a low level, the logic decoding module 13 performs decoding based on the second intermediate command/address signal B<11:0> corresponding to CA<11:0> to obtain another command signal. Therefore, it is ensured that in the normal mode and the power down mode, various required corresponding command signals can be successfully obtained through decoding.

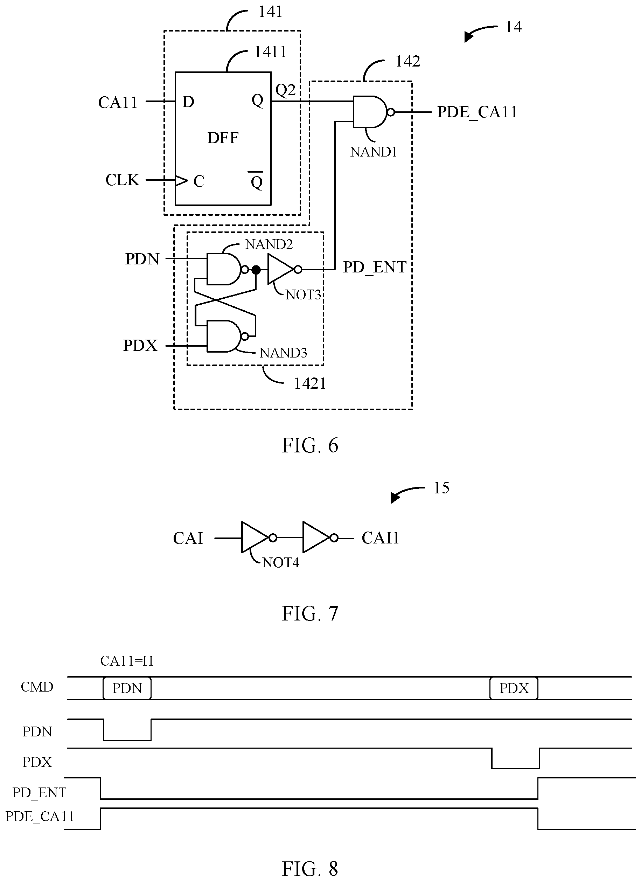

Further, as shown in FIG. 2, the control circuit 10 further includes a control signal generation module 14, and the control signal generation module 14 is configured to generate the command/address control signal PDE_CA11. For the control signal generation module 14, refer to FIG. 6, which is a schematic diagram of structural composition of a control signal generation module according to an embodiment of the present disclosure. As shown in FIG. 6, in some embodiments, the second intermediate command/address signal B<11:0> includes N bits of second intermediate command/address sub-signals, the control signal generation module 14 is connected to the logic control module 131, and is configured to receive a target command/address signal CA11, the target command/address signal is the nth bit of second intermediate command/address sub-signal in the N bits of second intermediate command/address sub-signals B<11:0>, and n is a positive integer less than or equal to N.

The control signal generation module 14 is further configured to: receive a clock signal CLK, the power down mode entry signal PDN, and the power down mode exit signal PDX; perform sampling processing on the target command/address signal CA11 based on the clock signal CLK to generate a second sampled signal Q2; and perform logical processing based on the second sampled signal Q2, the power down mode entry signal PDN, and the power down mode exit signal PDX to generate the command/address control signal PDE_CA11.

It should be noted that the target command/address signal may indicate whether the input processing sub-module can normally receive an initial command/address sub-signal. If the target command/address signal is at a low level, it indicates that input processing sub-modules corresponding to CA<0> to CA<4> can normally receive corresponding initial command/address sub-signals, so that the control circuit 10 can obtain PDX through decoding based on each initial command/address signal. If the target command/address signal is at a high level, it indicates that input processing sub-modules corresponding to CA<0> to CA<4> cannot receive corresponding initial command/address sub-signals. In this case, B<0> to B<4> are set to a high level, so that PDX is obtained through decoding. Herein, that the target command/address signal is B<11> (also denoted as CA11) in B<11:0> is taken as an example. However, this is not specifically limited.

It should be further noted that corresponding to the first intermediate command/address signal A<11:0>, the second intermediate command/address signal B<11:0> may include N bits of second intermediate command/address sub-signals. For example, N=12 and n=12. The 12 bits of second intermediate command/address sub-signals are respectively B<0>, B<1>, B<2>, ..., and B<11>, and the nth bit of second intermediate command/address sub-signal B<11> is the target command/address signal CA11. It may be understood that corresponding to the N bits of second intermediate command/address sub-signals B<11:0>, the N logic control sub-modules in the logic control module 131 each receive the command/address inversion signal CAI1 and a corresponding first intermediate command/address sub-signal, and output a corresponding second intermediate command/address sub-signal. In this case, an input terminal of the control signal generation module 14 is connected to the nth logic control sub-module, and is configured to receive the target command/address signal CA11 output by the nth logic control sub-module.

As shown in FIG. 6, in some embodiments, the control signal generation module 14 includes a second sampling module 141 and a third logic module 142.

The second sampling module 141 is configured to: receive the target command/address signal CA11 and the clock signal CLK, and perform sampling processing on the target command/address signal CA11 based on the clock signal CLK to obtain the second sampled signal Q2.

The third logic module 142 is configured to: receive the power down mode entry signal PDN, the power down mode exit signal PDX, and the second sampled signal Q2, generate a power down mode enable signal PD_ENT based on the power down mode entry signal PDN and the power down mode exit signal PDX, and perform a logical operation based on the second sampled signal Q2 and the power down mode enable signal PD_ENT to generate the command/address control signal PDE_CA11.

A power down mode enable signal PD_ENT in a valid state is generated when the power down mode entry signal PDN is in the valid state, so that the command/address control signal PDE_CA11 is in the enabled state; and a power down mode enable signal PD_ENT in an invalid state is generated when the power down mode exit signal PDX is in the valid state, so that the command/address control signal PDE_CA11 is in the disabled state.

It should be noted that as shown in FIG. 6, in the control signal generation module 14, an input terminal of the second sampling module 141 is configured to receive the target command/address signal CA11, a clock terminal of the second sampling module 141 is configured to receive the clock signal CLK, and an output terminal of the second sampling module 141 is connected to an input terminal of the third logic module 142. The second sampling module 141 performs sampling processing on the target command/address signal CA11 based on the clock signal CLK to obtain the second sampled signal Q2, and sends the second sampled signal Q2 to the third logic module 142.

The third logic module 142 further includes two other input terminals, respectively configured to receive the power down mode entry signal PDN and the power down mode exit signal PDX, and an output terminal of the third logic module 142 is configured to output the command/address control signal PDE_CA11.

In some embodiments, as shown in FIG. 6, the second sampling module 141 includes a first D flip-flop 1411, and the third logic module 142 includes a latch module 1421 and a first NAND gate NAND1.

An input terminal D of the first D flip-flop 1411 is configured to receive the target command/address signal CA11, a clock terminal C of the first D flip-flop 1411 is configured to receive the clock signal, an output terminal Q of the first D flip-flop 1411 is connected to a first input terminal of the first NAND gate NAND1, and the output terminal of the first D flip-flop 1411 is configured to output the second sampled signal Q2.

A first input terminal of the latch module 1421 is configured to receive the power down mode entry signal PDN, a second input terminal of the latch module 1421 is configured to receive the power down mode exit signal PDX, and an output terminal of the latch module 1421 is configured to output the power down mode enable signal PD_ENT.

A first input terminal of the first NAND gate NAND1 is connected to the output terminal of the first D flip-flop 1411, a second input terminal of the first NAND gate NAND1 is connected to the output terminal of the latch module 1421, and an output terminal of the first NAND gate NAND1 is configured to output the command/address control signal PDE_CA11.

It should be noted that as shown in FIG. 6, the second sampling module 141 may be implemented by a D flip-flop, e.g., the first D flip-flop 1411 shown in FIG. 6. The input terminal D of the first D flip-flop 1411 serves as the input terminal of the second sampling module 141, the clock terminal C of the first D flip-flop 1411 serves as the clock terminal of the second sampling module 141, and the output terminal Q of the first D flip-flop 1411 serves as the output terminal of the second sampling module 141. Two input terminals of the latch module 1421 serve as two input terminals of the third logic module 142, and are respectively configured to: receive the power down mode entry signal PDN and the power down mode exit signal PDX, obtain the power down mode enable signal PD_ENT based on the power down mode entry signal PDN and the power down mode exit signal PDX, and send the power down mode enable signal PD_ENT to the second input terminal of the first NAND gate NAND1. The first input terminal of the first NAND gate NAND1 servers as another input terminal of the third logic module 142, and is connected to the output terminal of the first D flip-flop 1411.

When the power down mode entry signal PDN is in the valid state and the power down mode exit signal PDX is in the invalid state, the latch module 1421 may obtain the power down mode enable signal PD_ENT in the valid state, which passes through the first NAND gate NAND 1, so that the command/address control signal PDE_CA11 is in the enabled state. When the power down mode exit signal PDX is in the valid state and the power down mode entry signal PDN is in the invalid state, the latch module 1421 may obtain the power down mode enable signal PD_ENT in the invalid state, which passes through the first NAND gate NAND1, so that the command/address control signal PDE_CA11 is in the disabled state.

It should be further noted that in this embodiment of the present disclosure, the power down mode entry signal PDN, the power down mode exit signal PDX, and the power down mode enable signal PD_ENT are described through an example in which the valid state of the signal is the logic 0 indicating the low level and the invalid state of the signal is the logic 1 indicating the high level. However, the valid state may be the logic 1 indicating the high level, and the invalid state may be the logic 0 indicating the low level. This is not specifically limited.

Further, for the latch module 1421, in some embodiments, as shown in FIG. 6, the latch module 1421 includes a second NAND gate NAND2, a third NAND gate NAND3, and a third NOT gate NOT3.

A first input terminal of the second NAND gate NAND2 is configured to receive the power down mode entry signal PDN, a second input terminal of the second NAND gate NAND2 is connected to an output terminal of the third NAND gate NAND3, an output terminal of the second NAND gate NAND2 is separately connected to a first input terminal of the third NAND gate NAND3 and an input terminal of the third NOT gate NOT3, a second input terminal of the third NAND gate NAND3 is configured to receive the power down mode exit signal PDX, and an output terminal of the third NOT gate NOT3 is connected to the second input terminal of the first NAND gate NAND1.

It should be noted that as shown in FIG. 6, the first input terminal of the second NAND gate NAND2 and the second input terminal of the third NAND gate NAND3 respectively serve as two input terminals of the latch module 1421, and the output terminal of the third NOT gate NOT3 serves as the output terminal of the latch module 1421.

The second NAND gate NAND2 and the third NAND gate NAND3 form a latch, a port receiving the power down mode entry signal PDN serves as a set terminal S of the latch, and a port receiving the power down mode exit signal PDX serves as a reset terminal R of the latch. The latch performs latch processing based on the power down mode entry signal PDN and the power down mode exit signal PDX to obtain a latch signal, and then the third NOT gate NOT3 performs inversion processing on the latch signal to obtain the power down mode enable signal PD_ENT.

Further, as shown in FIG. 2, in some embodiments, the control circuit 10 further includes an input inversion buffer module 15.

The input inversion buffer module 15 is configured to: receive an input inversion signal CAI, and perform drive enhancement processing on the input inversion signal CAI to obtain the command/address inversion signal CAI1.

It should be noted that when command/address inversion exists, the input inversion buffer module 15 (also referred to as a CAI buffer) in the control circuit receives an initial command/address inversion signal (that is, the input inversion signal CAI), and performs drive enhancement processing to obtain the command/address inversion signal CAI1.

FIG. 7 is a schematic diagram of structural composition of an input inversion buffer module according to an embodiment of the present disclosure. As shown in FIG. 7, the input inversion buffer module 15 includes an even-numbered quantity of fourth NOT gates NOT4 connected in series.

It should be noted that as shown in FIG. 7, in the input inversion buffer module 15, an input terminal of the first fourth NOT gate NOT4 serves as an input terminal of the input inversion buffer module 15, and is configured to receive the input inversion signal CAI, and an output terminal of the last fourth NOT gate NOT4 serves as an output terminal of the input inversion buffer module 15, and is configured to output the command/address inversion signal CAI1. Two fourth NOT gates NOT4 are shown in FIG. 7, but there may be four, six, eight, or another quantity of fourth NOT gates. This is not specifically limited herein.

Because there are an even-numbered quantity of fourth NOT gates NOT4, a level state of a signal is not changed, and only a drive enhancement effect is achieved for the signal, thereby ensuring a drive capability of the signal.

A circuit structure shown in FIG. 6 is taken as an example. FIG. 8 is a schematic diagram of corresponding signal timing. As shown in FIG. 8, when the target command/address signal CA11 is at a high level (H), the control circuit is in the power down mode in a time period from a time at which the power down mode entry signal PDN is in the valid state (at a low level) to a time at which the power down mode exit signal PDX is in the valid state (at a low level). In this time period, the power down mode enable signal PD_ENT in the valid state (at a low level) is generated, to obtain the command/address control signal PDE _CA11 in the enabled state (at a high level). Further, referring to FIG. 4, the command/address control signal PDE_CA11 at a high level enables both the second P-type transistor P2 and the second N-type transistor N2 to be turned off, so that level states of both the first drive control signal A and the second drive control signal B are consistent with that of the command/address inversion signal CAI1. Referring to FIG. 2, the command/address control signal PDE_CA11 at a high level enables the input buffer module 121 to enter the non-working state and the drive module 122 to enter the working state, then the first intermediate command/address signal A<11:0> is generated based on the first drive control signal A and the second drive control signal B whose level states are consistent with that of the command/address inversion signal CAI1, and further decoding is performed to generate the power down mode exit signal PDX.

It may be learned that when the control circuit is in the power down mode, the command/address control signal PDE_CA11 may be generated based on the target command/address signal CA11 in this embodiment of the present disclosure, so that even if the CA buffer (that is, the input buffer module 121) does not work in the power down mode, the output of the input buffer module 121 can be controlled through the drive module 122, to ensure that the power down mode exit signal PDX is successfully obtained through decoding.

Based on the circuit structure provided in this embodiment of the present disclosure, Table 2 shows a level state of a related signal and an output of each module.

**Table 2**

| PDE_CA11 | CAI | A | B | Explanation |
|---|---|---|---|---|
| L | × | H | L | The CA buffer is enabled |
| H | L | L | L | In the power down mode, CAI is disabled and an output of A<11:0> is H |
| H | H | H | H | In the power down mode, CAI is enabled and an output of A<11:0> is L |

As shown in Table 2, L represents the low-level state, and H represents the high-level state. In the normal mode, the CAI signal is ×, which indicates that the CAI buffer (that is, the input inversion buffer module) is disabled (does not work). In this case, the command/address control signal PDE_CA11 is in the invalid state (the low-level state). Therefore, after processing by the input control module 11, the obtained first drive control signal A is in the high-level state, the second drive control signal B is in the low-level state, both the first P-type transistor P1 and the first N-type transistor N1 are turned off, the drive module 122 does not work, the CA buffer (that is, the input buffer module 121) is enabled, and works normally, and the first intermediate command/address signal A<11:0> is obtained based on the external command/address signal CA<11:0>.

In the power down mode, the CAI buffer works. In this case, the command/address control signal PDE_CA11 is in the valid state (the high-level state), and the level states of the first drive control signal A and the second drive control signal B are the same as that of the CAI signal (that is, the input inversion signal). When the CAI signal is at a low level, CAI is disabled, the first P-type transistor P1 is turned on, and the first N-type transistor N1 is turned off, so that the first P-type transistor P1 can transmit, to the output terminal of the CA buffer, the high level provided by the power supply terminal VDD, and an output of the CA buffer is set to a high level, to output the first intermediate command/address signal A<11:0> at a high level. When the CAI signal is at a high level, CAI is enabled, the first P-type transistor P1 is turned off, and the first N-type transistor N1 is turned on, so that the first N-type transistor N1 can transmit, to the output terminal of the CA buffer, the low level provided by the ground terminal VSS, and an output of the CA buffer is set to a low level, to output the first intermediate command/address signal A<11:0> at a low level.

In short, when the chip, comprising the control circuit, enters the power down mode, the command/address control signal PDE_CA11 becomes into a high level. Through the input control module (control block), information about the command/address control signal PDE CA11 and the CAI signal is recompiled and controlled to generate the first drive control signal A and the second drive control signal B, and an output state of the CA buffer (the input buffer module) in the disabled state is controlled, so that the first intermediate command/address signal A<11:0> can be correctly transmitted to the logic decoding module 13 regardless of whether CAI is enabled or disabled, to ensure that the power down mode exit signal can be successfully obtained through decoding, so as to reduce power consumption and implement a normal function in the power down mode of the memory (e.g., DDR5).

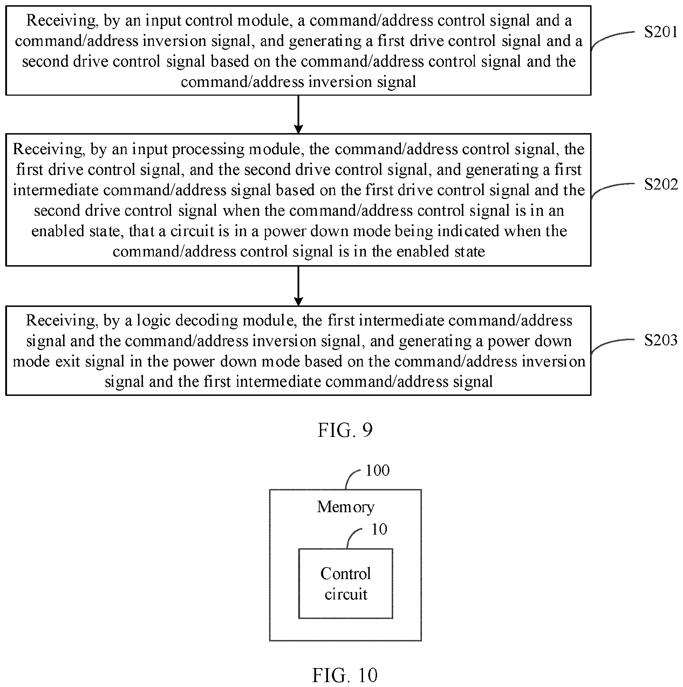

In another embodiment of the present disclosure, refer to FIG. 9, which is a schematic flowchart of a control method according to an embodiment of the present disclosure. As shown in FIG. 9, the method may include the steps as follows.

In the step of S201, a command/address control signal and a command/address inversion signal are received by an input control module, and a first drive control signal and a second drive control signal are generated based on the command/address control signal and the command/address inversion signal.

In the step of S202, the command/address control signal, the first drive control signal, and the second drive control signal are received by an input processing module, and a first intermediate command/address signal is generated based on the first drive control signal and the second drive control signal when the command/address control signal is in an enabled state. That a circuit is in a power down mode is indicated when the command/address control signal is in the enabled state.

In the step of S203, the first intermediate command/address signal and the command/address inversion signal are received by a logic decoding module, and a power down mode exit signal is generated in the power down mode based on the command/address inversion signal and the first intermediate command/address signal.

In some embodiments, the method may further include the steps as follows.

An external command/address signal is received by the input processing module, and the first intermediate command/address signal is generated based on the external command/address signal when the command/address control signal is in a disabled state. That the circuit is in a normal mode is indicated when the command/address control signal is in the disabled state.

A power down mode entry signal is generated by the logic decoding module in the normal mode based on the command/address inversion signal and the first intermediate command/address signal.

In some embodiments, that the first intermediate command/address signal is generated based on the external command/address signal when the command/address control signal is in a disabled state may include the step as follows.

The command/address control signal and the external command/address signal are received by an input buffer module, and drive enhancement processing is performed on the external command/address signal to obtain the first intermediate command/address signal when the command/address control signal is in the disabled state.

That a first intermediate command/address signal is generated based on the first drive control signal and the second drive control signal when the command/address control signal is in an enabled state may include the step as follows.

The first drive control signal and the second drive control signal are received by a drive module, and the first intermediate command/address signal is generated based on the first drive control signal and the second drive control signal when the command/address control signal is in the enabled state.

In some embodiments, that the first intermediate command/address signal is generated based on the first drive control signal and the second drive control signal may include the steps as follows.

The first drive control signal is received by a pull-up module, and an output terminal of the drive module is pulled up to a second level state when the first drive control signal is in a first level state, so that the first intermediate command/address signal is in the second level state.

The second drive control signal is received by a pull-down module, and the output terminal of the drive module is pulled down to the first level state when the second drive control signal is in the second level state, so that the first intermediate command/address signal is in the first level state.

In some embodiments, the external command/address signal includes N bits of external command/address sub-signals, the first intermediate command/address signal includes N bits of first intermediate command/address sub-signals, and N is a positive integer; and that drive enhancement processing is performed on the external command/address signal to obtain the first intermediate command/address signal may include the step as follows.

1 bit of external command/address sub-signal and the command/address control signal are correspondingly received by an input buffer sub-module, and 1 bit of first intermediate command/address sub-signal is generated based on the 1 bit of external command/address sub-signal when the command/address control signal is in the disabled state.

In some embodiments, the first drive control signal is in the second level state and the second drive control signal is in the first level state when the command/address control signal is in the disabled state; and
the first drive control signal and the second drive control signal are in the same level state when the command/address control signal is in the enabled state.

In some embodiments, that a first drive control signal and a second drive control signal are generated based on the command/address control signal and the command/address inversion signal may include the steps as follows.

The command/address control signal and the command/address inversion signal are received by a first input control module, and the first drive control signal is generated based on the command/address control signal and the command/address inversion signal.

The command/address control signal and the command/address inversion signal are received by a second input control module, and the second drive control signal is generated based on the command/address control signal and the command/address inversion signal.

In some embodiments, that the command/address control signal and the command/address inversion signal are received by a first input control module, and the first drive control signal is generated based on the command/address control signal and the command/address inversion signal may include the steps as follows.

The command/address control signal and the command/address inversion signal are received by a first logic module, and a first intermediate drive control signal is generated based on the command/address control signal and the command/address inversion signal.

The first intermediate drive control signal is received by a first buffer module, and drive enhancement processing is performed on the first intermediate drive control signal to generate the first drive control signal.

That the command/address control signal and the command/address inversion signal are received by a second input control module, and the second drive control signal is generated based on the command/address control signal and the command/address inversion signal may include the steps as follows.

The command/address control signal and the command/address inversion signal are received by a second logic module, and a second intermediate drive control signal is generated based on the command/address control signal and the command/address inversion signal.

The second intermediate drive control signal is received by a second buffer module, and drive enhancement processing is performed on the second intermediate drive control signal to generate the second drive control signal.

In some embodiments, that a power down mode exit signal is generated based on the command/address inversion signal and the first intermediate command/address signal may include the steps as follows.

The first intermediate command/address signal and the command/address inversion signal are received by a logic control module, and logical processing is performed based on the command/address inversion signal and the first intermediate command/address signal to generate a second intermediate command/address signal.

The second intermediate command/address signal is received by a first sampling module, to perform sampling processing on the second intermediate command/address signal to obtain a first sampled signal.

The first sampled signal is received by a decoding module, to perform decoding processing on the first sampled signal to obtain the power down mode exit signal.

In some embodiments, that logical processing is performed based on the command/address inversion signal and the first intermediate command/address signal to generate a second intermediate command/address signal includes the step as follows.

The second intermediate command/address signal is controlled to be in the same level state as the first intermediate command/address signal when the command/address inversion signal is in the first level state; or the second intermediate command/address signal is controlled to be in an opposite level state to the first intermediate command/address signal when the command/address inversion signal is in the second level state.

In some embodiments, the second intermediate command/address signal includes N bits of second intermediate command/address sub-signals, and in some embodiments, the method may further include the step as follows.

A clock signal, the power down mode entry signal, and the power down mode exit signal are received by a control signal generation module; sampling processing is performed on a target command/address signal based on the clock signal to generate a second sampled signal; and logical processing is performed based on the second sampled signal, the power down mode entry signal, and the power down mode exit signal to generate the command/address control signal. The target command/address signal is the nth bit of second intermediate command/address sub-signal in the N bits of second intermediate command/address sub-signals, and n is a positive integer less than or equal to N.

In some embodiments, that sampling processing is performed on a target command/address signal based on the clock signal to generate a second sampled signal may include the step as follows.

The target command/address signal and the clock signal are received by a second sampling module, and sampling processing is performed on the target command/address signal based on the clock signal to obtain the second sampled signal.

That logical processing is performed based on the second sampled signal, the power down mode entry signal, and the power down mode exit signal to generate the command/address control signal may include the step as follows.

The power down mode entry signal, the power down mode exit signal, and the second sampled signal are received by a third logic module, a power down mode enable signal is generated based on the power down mode entry signal and the power down mode exit signal, and a logical operation is performed based on the second sampled signal and the power down mode enable signal to generate the command/address control signal.

A power down mode enable signal in a valid state is generated when the power down mode entry signal is in the valid state, so that the command/address control signal is in the enabled state; and a power down mode enable signal in an invalid state is generated when the power down mode exit signal is in the valid state, so that the command/address control signal is in the disabled state.

In some embodiments, the method may further include the step as follows.

An input inversion signal is received by an input inversion buffer module, and drive enhancement processing is performed on the input inversion signal to obtain the command/address inversion signal.

It should be noted that this embodiment of the present disclosure is applied to the control circuit 10 in the foregoing embodiment. For details not disclosed in this embodiment of the present disclosure, refer to the descriptions of the foregoing embodiment.

This embodiment of the present disclosure provides a control method. The first intermediate command/address signal is generated based on the first drive control signal and the second drive control signal when the command/address control signal is in the enabled state, and then the power down mode exit signal is generated. This ensures that the power down mode exit signal can be successfully obtained through decoding when CAI is enabled, so that the circuit can smoothly exit the power down mode, thereby facilitating normal working of a memory, and improving performance of the memory.

In still another embodiment of the present disclosure, refer to FIG. 10, which is a schematic diagram of structural composition of a memory 100 according to an embodiment of the present disclosure. As shown in FIG. 10, the memory 100 may include at least the control circuit 10 described in any one of the foregoing embodiments.

In some embodiments, the memory 100 is a semiconductor memory, such as a dynamic random access memory DRAM chip.

In this embodiment of the present disclosure, the DRAM may not only meet a memory specification such as DDR, DDR2, DDR3, DDR4, and DDR5, but also meet a memory specification such as LPDDR, LPDDR2, LPDDR3, LPDDR4, and LPDDR5. This is not limited herein.

In this embodiment of the present disclosure, because the memory 100 includes the control circuit 10 in the foregoing embodiment, it can be ensured that the power down mode exit signal can be successfully obtained through decoding when CAI is enabled, so that the memory can smoothly exit the power down mode, thereby facilitating normal working of the memory, and improving performance of the memory.

The foregoing descriptions are merely example embodiments of the present disclosure, and are not intended to limit the protection scope of the present disclosure.

It should be noted that in the present disclosure, the terms "include", "comprise", or any other variant thereof are intended to cover non-exclusive inclusion, so that a process, method, article, or apparatus that includes a series of elements includes not only those elements but also other elements that are not expressly listed, or further includes elements inherent to such a process, method, article, or apparatus. An element preceded by "includes a ..." does not, without more constraints, preclude the presence of additional identical elements in the process, method, article, or apparatus that includes the element.

The sequence numbers of the foregoing embodiments of the present disclosure are merely for the purpose of description, and do not represent priorities of the embodiments.

The methods disclosed in the several method embodiments provided in the present disclosure may be randomly combined when there is no conflict, to obtain new method embodiments.

The features disclosed in the several product embodiments provided in the present disclosure may be randomly combined when there is no conflict, to obtain new product embodiments.

The features disclosed in the several method or device embodiments provided in the present disclosure may be randomly combined when there is no conflict, to obtain new method embodiments or new device embodiments.

The foregoing descriptions are merely specific implementations of the present disclosure, but are not intended to limit the protection scope of the present disclosure. Any variation or replacement readily figured out by a person skilled in the art within the technical scope disclosed in the present disclosure shall fall within the protection scope of the present disclosure. Therefore, the protection scope of the present disclosure shall be subject to the protection scope of the claims.

### Industrial applicability

The embodiments provide a control circuit, a control method, and a memory. In the control circuit, an input control module is configured to: receive a command/address control signal and a command/address inversion signal, and generate a first drive control signal and a second drive control signal based on the command/address control signal and the command/address inversion signal; an input processing module is configured to: receive the command/address control signal, the first drive control signal, and the second drive control signal, and generate a first intermediate command/address signal based on the first drive control signal and the second drive control signal when the command/address control signal is in an enabled state, that the circuit is in a power down mode being indicated when the command/address control signal is in the enabled state; and a logic decoding module is configured to: receive the first intermediate command/address signal and the command/address inversion signal, and generate a power down mode exit signal in the power down mode based on the command/address inversion signal and the first intermediate command/address signal. In this way, the first intermediate command/address signal is generated based on the first drive control signal and the second drive control signal when the command/address control signal is in the enabled state, and then the power down mode exit signal is generated. This ensures that the power down mode exit signal can be successfully obtained through decoding when CAI is enabled, thereby facilitating normal working of a memory, and improving performance.

## Claims

1. A control circuit (10), comprising:
an input control module (11), configured to: receive a command/address control signal and a command/address inversion signal, and generate a first drive control signal and a second drive control signal based on the command/address control signal and the command/address inversion signal;
an input processing module (12), configured to: receive the command/address control signal, the first drive control signal, and the second drive control signal, and generate a first intermediate command/address signal based on the first drive control signal and the second drive control signal when the command/address control signal is in an enabled state, that the circuit is in a power down mode being indicated when the command/address control signal is in the enabled state; and
a logic decoding module (13), configured to: receive the first intermediate command/address signal and the command/address inversion signal, and generate a power down mode exit signal in the power down mode based on the command/address inversion signal and the first intermediate command/address signal.

2. The control circuit (10) according to claim 1, wherein
the input processing module (12) is further configured to: receive an external command/address signal, and generate the first intermediate command/address signal based on the external command/address signal when the command/address control signal is in a disabled state, that the circuit is in a normal mode being indicated when the command/address control signal is in the disabled state; and
the logic decoding module (13) is further configured to generate a power down mode entry signal in the normal mode based on the command/address inversion signal and the first intermediate command/address signal.

3. The control circuit (10) according to claim 2, wherein the input processing module (12) comprises an input buffer module (121) and a drive module (122); and an output terminal of the input buffer module (121) and an output terminal of the drive module (122) are connected as an output terminal of the input processing module (12), and are connected to the logic decoding module (13);
the input buffer module (121) is configured to: receive the command/address control signal and the external command/address signal, and perform drive enhancement processing on the external command/address signal to obtain the first intermediate command/address signal and output the first intermediate command/address signal from the output terminal of the input buffer module (121) when the command/address control signal is in the disabled state; and
the drive module (122) is configured to: receive the first drive control signal and the second drive control signal, and generate the first intermediate command/address signal based on the first drive control signal and the second drive control signal and output the first intermediate command/address signal from the output terminal of the drive module (122) when the command/address control signal is in the enabled state.

4. The control circuit (10) according to claim 3, wherein the drive module (122) comprises a pull-up module (1221) and a pull-down module (1222);
the pull-up module (1221) is configured to: receive the first drive control signal, and pull up the output terminal of the drive module (122) to a second level state when the first drive control signal is in a first level state, so that the first intermediate command/address signal is in the second level state; and
the pull-down module (1222) is configured to: receive the second drive control signal, and pull down the output terminal of the drive module (122) to the first level state when the second drive control signal is in the second level state, so that the first intermediate command/address signal is in the first level state.

5. The control circuit (10) according to claim 3, wherein the external command/address signal comprises N bits of external command/address sub-signals, the first intermediate command/address signal comprises N bits of first intermediate command/address sub-signals, and N is a positive integer; and
the input buffer module (121) comprises N input buffer sub-modules, and each input buffer sub-module correspondingly receives 1 bit of external command/address sub-signal and the command/address control signal, and generates 1 bit of first intermediate command/address sub-signal based on the 1 bit of external command/address sub-signal when the command/address control signal is in the disabled state.

6. The control circuit (10) according to claim 4, wherein the pull-up module (1221) comprises a first P-type transistor (P1), and the pull-down module (1222) comprises a first N-type transistor (N1; and
a gate terminal of the first P-type transistor (P1) is configured to receive the first drive control signal, a first terminal of the first P-type transistor (P1) is connected to a power supply terminal, a gate terminal of the first N-type transistor (N1) is configured to receive the second drive control signal, a first terminal of the first N-type transistor (N1) is connected to a ground terminal, and a second terminal of the first P-type transistor (P1) and a second terminal of the first N-type transistor (N1) are connected as the output terminal of the drive module (122), and are configured to output the first intermediate command/address signal.

7. The control circuit (10) according to any one of claims 1 to 6, wherein
the first drive control signal is in the second level state and the second drive control signal is in the first level state when the command/address control signal is in the disabled state; and
the first drive control signal and the second drive control signal are in a same level state when the command/address control signal is in the enabled state.

8. The control circuit (10) according to any one of claims 1 to 7, wherein the input control module (11) comprises a first input control module (111) and a second input control module (112);
the first input control module (111) is configured to: receive the command/address control signal and the command/address inversion signal, and generate the first drive control signal based on the command/address control signal and the command/address inversion signal; and
the second input control module (112) is configured to: receive the command/address control signal and the command/address inversion signal, and generate the second drive control signal based on the command/address control signal and the command/address inversion signal.

9. The control circuit (10) according to claim 8, wherein the first input control module (111) comprises a first logic module (1111) and a first buffer module (1112), and the second input control module (112) comprises a second logic module (1121) and a second buffer module (1122);
the first logic module (1111) is configured to: receive the command/address control signal and the command/address inversion signal, and generate a first intermediate drive control signal based on the command/address control signal and the command/address inversion signal;
the first buffer module (1112) is configured to perform drive enhancement processing on the first intermediate drive control signal to generate the first drive control signal;
the second logic module (1121) is configured to: receive the command/address control signal and the command/address inversion signal, and generate a second intermediate drive control signal based on the command/address control signal and the command/address inversion signal; and
the second buffer module (1122) is configured to perform drive enhancement processing on the second intermediate drive control signal to generate the second drive control signal.

10. The control circuit (10) according to claim 9, wherein
the first logic module (1111) comprises a first tri-state gate (TS1) and a second P-type transistor (P2), an input terminal of the first tri-state gate (TS1) is configured to receive the command/address inversion signal, both a control terminal of the first tri-state gate (TS1) and a gate terminal of the second P-type transistor (P2) are configured to receive the command/address control signal, a first terminal of the second P-type transistor (P2) is connected to a power supply terminal, and both a second terminal of the second P-type transistor (P2) and an output terminal of the first tri-state gate (TS1) are connected to an input terminal of the first buffer module (1112); and
the second logic module (1121) comprises a second tri-state gate (TS2), a first NOT gate (NOT1), and a second N-type transistor (N2), an input terminal of the second tri-state gate (TS2) is configured to receive the command/address inversion signal, both a control terminal of the second tri-state gate (TS2) and an input terminal of the first NOT gate (NOT1) are configured to receive the command/address control signal, an output terminal of the first NOT gate (NOT1) is connected to a gate terminal of the second N-type transistor (N2), a first terminal of the second N-type transistor (N2) is connected to a ground terminal, and both a second terminal of the second N-type transistor (N2) and an output terminal of the second tri-state gate (TS2) are connected to an input terminal of the second buffer module (1122).

11. The control circuit (10) according to claim 9, wherein each of the first buffer module (1112) and the second buffer module (1122) comprises an even-numbered quantity of second NOT gates (NOT2) connected in series.

12. The control circuit (10) according to any one of claims 1 to 11, wherein the logic decoding module (13) comprises a logic control module (131), and an input terminal of the logic control module (131) is connected to the output terminal of the input processing module (12); and
the logic control module (131) is configured to: receive the first intermediate command/address signal and the command/address inversion signal, and perform logical processing based on the command/address inversion signal and the first intermediate command/address signal to generate a second intermediate command/address signal.

13. The control circuit (10) according to claim 12, wherein
the logic control module (131) is configured to: control the second intermediate command/address signal to be in a same level state as the first intermediate command/address signal when the command/address inversion signal is in the first level state; or control the second intermediate command/address signal to be in an opposite level state to the first intermediate command/address signal when the command/address inversion signal is in the second level state.

14. The control circuit (10) according to claim 13, wherein the logic decoding module (13) further comprises a first sampling module (132) and a decoding module (133), an input terminal of the first sampling module (132) is connected to an output terminal of the logic control module (131), and an input terminal of the decoding module (133) is connected to an output terminal of the first sampling module (132);
the first sampling module (132) is configured to perform sampling processing on the second intermediate command/address signal to obtain a first sampled signal; and
the decoding module (133) is configured to perform decoding processing on the first sampled signal to obtain the power down mode exit signal.

15. The control circuit (10) according to claim 12, wherein the second intermediate command/address signal comprises N bits of second intermediate command/address sub-signals, the control circuit (10) further comprises a control signal generation module (14), the control signal generation module (14) is connected to the logic control module (131), and is configured to receive a target command/address signal, the target command/address signal is an nth bit of second intermediate command/address sub-signal in the N bits of second intermediate command/address sub-signals, and n is a positive integer less than or equal to N; and
the control signal generation module (14) is further configured to: receive a clock signal, the power down mode entry signal, and the power down mode exit signal; perform sampling processing on the target command/address signal based on the clock signal to generate a second sampled signal; and perform logical processing based on the second sampled signal, the power down mode entry signal, and the power down mode exit signal to generate the command/address control signal.

16. The control circuit (10) according to claim 15, wherein the control signal generation module (14) comprises a second sampling module (141) and a third logic module (142);
the second sampling module (141) is configured to: receive the target command/address signal and the clock signal, and perform sampling processing on the target command/address signal based on the clock signal to obtain the second sampled signal;
the third logic module (142) is configured to: receive the power down mode entry signal, the power down mode exit signal, and the second sampled signal, generate a power down mode enable signal based on the power down mode entry signal and the power down mode exit signal, and perform a logical operation based on the second sampled signal and the power down mode enable signal to generate the command/address control signal; and
a power down mode enable signal in a valid state is generated when the power down mode entry signal is in the valid state, so that the command/address control signal is in the enabled state; and a power down mode enable signal in an invalid state is generated when the power down mode exit signal is in the valid state, so that the command/address control signal is in the disabled state.

17. The control circuit (10) according to claim 16, wherein the second sampling module (141) comprises a first D flip-flop (1411), and the third logic module (142) comprises a latch module (1421) and a first NAND gate (NAND1);
an input terminal of the first D flip-flop (1411) is configured to receive the target command/address signal, a clock terminal of the first D flip-flop (1411) is configured to receive the clock signal, an output terminal of the first D flip-flop (1411) is connected to a first input terminal of the first NAND gate (NAND1), and the output terminal of the first D flip-flop (1411) is configured to output the second sampled signal;
a first input terminal of the latch module (1421) is configured to receive the power down mode entry signal, a second input terminal of the latch module (1421) is configured to receive the power down mode exit signal, and an output terminal of the latch module (1421) is configured to output the power down mode enable signal; and
a second input terminal of the first NAND gate (NAND1) is connected to the output terminal of the latch module (1421), and an output terminal of the first NAND gate (NAND1) is configured to output the command/address control signal.

18. The control circuit (10) according to claim 17, wherein the latch module (1421) comprises a second NAND gate (NAND2), a third NAND gate (NAND3), and a third NOT gate (NOT3); and
a first input terminal of the second NAND gate (NAND2) is configured to receive the power down mode entry signal, a second input terminal of the second NAND gate (NAND2) is connected to an output terminal of the third NAND gate (NAND3), an output terminal of the second NAND gate (NAND2) is separately connected to a first input terminal of the third NAND gate (NAND3) and an input terminal of the third NOT gate (NOT3), a second input terminal of the third NAND gate (NAND3) is configured to receive the power down mode exit signal, and an output terminal of the third NOT gate (NOT3) is connected to the second input terminal of the first NAND gate (NAND1).

19. The control circuit (10) according to any one of claims 1 to 18, wherein the control circuit (10) further comprises an input inversion buffer module (15); and
the input inversion buffer module (15) is configured to: receive an input inversion signal, and perform drive enhancement processing on the input inversion signal to obtain the command/address inversion signal.

20. The control circuit (10) according to claim 19, wherein the input inversion buffer module (15) comprises an even-numbered quantity of fourth NOT gates (NOT4) connected in series.

21. A control method, comprising:
receiving, by an input control module (11), a command/address control signal and a command/address inversion signal, and generating a first drive control signal and a second drive control signal based on the command/address control signal and the command/address inversion signal;
receiving, by an input processing module (12), the command/address control signal, the first drive control signal, and the second drive control signal, and generating a first intermediate command/address signal based on the first drive control signal and the second drive control signal when the command/address control signal is in an enabled state, that a circuit is in a power down mode being indicated when the command/address control signal is in the enabled state; and
receiving, by a logic decoding module (13), the first intermediate command/address signal and the command/address inversion signal, and generating a power down mode exit signal in the power down mode based on the command/address inversion signal and the first intermediate command/address signal.

22. A memory (100), comprising the control circuit (10) according to any one of claims 1 to 20.
